# EUROPÄISCHE PATENTSCHRIFT

(11) **EP 2 959 585 B1**
(45) Veröffentlichungstag und Bekanntmachung des Hinweises auf die Patenterteilung: **17.08.2016**
(21) Anmeldenummer: 14707952.9
(22) Anmeldetag: 06.02.2014
(51) Int. Cl.: H03K 17/96, H05K 1/02

(54) **BEDIENEINHEIT FÜR EINE KAFFEEMASCHINE**
OPERATING UNIT FOR A COFFEE MACHINE
UNITÉ DE COMMANDE POUR UNE CAFETIÈRE ÉLECTRIQUE

(30) Priorität: 20.02.2013 DE 202013100760 U
(43) Veröffentlichungstag der Anmeldung: 30.12.2015
(73) Patentinhaber: Eugster/Frismag AG, 8580 Amriswil (CH)
(72) Erfinder: REINHART, Stefan, CH-8581 Schocherswil (CH); WAGER, Simon, CH-8580 Amriswil (CH); RIESSBECK, Wolfgang, CH-8597 Landschlacht (CH)
(74) Vertreter: Wagner, Kilian
(86) Internationale Anmeldenummer: PCT/EP2014/052352
(87) Internationale Veröffentlichungsnummer: WO 2014/128005

(56) Entgegenhaltungen:
- EP-A1- 2 337 225
- EP-A2- 1 924 000
- DE-U1-202009 007 911

## Beschreibung

Die vorliegende Erfindung betrifft eine Kaffeemaschine nach dem Oberbegriff des Anspruchs 1 sowie ein Kaffeemaschinenmontageverfahren gemäß Anspruch 15.

Aus dem Stand der Technik ist es bekannt, Kaffeemaschinen durch berührungsempfindliche Bedienelemente mit Berührungssensoren zu steuern. Insbesondere kommen dabei leitende Flächen zum Einsatz, mit denen man als kapazitive Elemente eine Berührung detektieren kann.

Mit solchen Bedienelementen lässt sich über Logikmittel, insbesondere in Form von Mikrokontrollern oder dergleichen, die Kaffeemaschine steuern, insbesondere indem weitere Elemente wie insbesondere Wassererhitzungsmittel, ein Mahlwerk und/oder eine Brüheinheit angesteuert werden. Beispielsweise lässt sich durch die Bedienelemente die Art des gewünschten Getränks und/oder der Röstgrad wählen. Die Logikmittel detektieren anhand der Änderungen der kapazitiven Eigenschaften der Berührungssensoren eine Berührung und reagieren auf vorgegebene Weise darauf. Solche Logikmittel sind insbesondere als sogenannte surface-mounted device (SMD, deutsch: oberflächenmontiertes Bauelement) Bauteile verbreitet.

Oft wird für die Außenform von Kaffeemaschinen, insbesondere für die Frontblenden, aus gestalterischen Gründen eine nicht ebene Form gewählt. Da die Bedienelemente in ihrer Außenkontur an diese Form angepasst sein müssen, kommen flexible Leiterfolien zum Einsatz, beispielsweise mit Silber bedruckte PE-Folien oder transparente mit Indium-ZinnOxid (ITO) beschichtete Folien, auf die die Bedienelemente aufgebracht werden.

Solche Leiterfolien eignen sich jedoch nur schlecht zu einer Bestückung mit handelsüblichen SMD-Bauteilen, da SMD Bauteile grundsätzlich nur für eine Bestückung auf einer flachen Leiterplatte ausgebildet und vorgesehen sind.

Unter anderem deshalb werden die Logikmittel und weitere SMD-Bauteile wie Messwiderstände auf zusätzlichen Leiterplatten angeordnet, die in einem hinteren bzw. inneren Bereich der Kaffeemaschine angeordnet sind.

Über lange Signalleitungen wird das Bediensignal der Berührungssensoren, meist über mehrere Steckverbindungen, an die weiteren Leiterplatten geleitet. Hierdurch entstehen mehrere Kontaktstellen und Störkapazitäten, die einer genauen Auswertung der Bediensignale entgegen stehen. Auch wird durch diese zusätzlichen Leitungen der Konstruktions- und Montageaufwand erhöht.

Aus der DE 10 2006 013 937 A1 ist eine Bedienblendenanordnung für Waschmaschinen und Wäschetrockner bekannt, bei welcher Elektroden zur Berechnung einer Bedienfingerposition und Auswertemittel auf einer durchgehend gekrümmten Leiterplatte angeordnet sind. Bei einem Verbiegen der Leiterplatte kann es hier zu Haarrissen in Signalleitungsmitteln (Leiterbahnen) kommen.

Aus der US 2006/0238513 A1 ist ein berührungssensitives Bedienelement bekannt, wobei berührungssensitive Sensoren über Kabel mit auf einer beabstandeten Leiterplatte angeordneten Logikmitteln verbunden sind.

Ein ähnlicher Aufbau ergibt sich bei einem in der DE 10 2007 035 455 A1 gezeigten kapazitiven Berührungsschalter.

Die DE 10 2011 077 902 A1 zeigt eine Bedien- und Anzeigeeinrichtung für Haushaltsgeräte mit auf einer geraden Leiterplatte angeordneten Sensorelektroden, wobei der durchgehend geraden Leiterplatte eine gekrümmte Bedienfläche vorgeordnet ist.

Die DE 10 2010 032 951 A1 zeigt eine durchgehend gekrümmte Trägerplatte für einen kapazitiven Berührungssensor, wobei die Trägerplatte über eine flexible Anbindung mit einer separaten Leiterplatte mit Auswerteelektronik verbunden ist.

Die DE 10 2011 078 985 A1 lehr Möglichkeiten zur Berührungserfassung von dreidimensionalen Objekten.

Aus der EP 2 337 225 A1 ist ein Haushaltgerät bekannt, das eine Leiterplatte aufweist, die einen Logikmittelabschnitt und einen einstückig damit verbundenen, flächenkleineren als Lasche ausgebildeten Sensormittelabschnitt aufweist. Der Sensormittelabschnitt trägt LEDs und kann manuell relativ zu dem nicht verformten Logikmittelabschnitt ausgelenkt werden.

Aufgabe der vorliegenden Erfindung ist es somit, eine Kaffeemaschine anzugeben, die die vorgenannten Nachteile nicht aufweist, insbesondere bei der ein nicht ebenes Bedienelement möglichst störungsfrei betrieben werden kann, wobei gleichzeitig der Montageaufwand reduziert wird. Aufgabe ist es auch, ein Montageverfahren anzugeben, das eine Montage der Kaffeemaschine ermöglicht, ohne dass es trotz eines nicht ebenen Bedienelementes nicht zu einer Schädigung von Komponenten kommt.

Diese Aufgabe wird durch eine Kaffeemaschine mit den Merkmalen des Anspruchs 1 gelöst. Als Berühren im Sinne von Patentanspruch 1 ist hierbei nicht zwingend ein unmittelbarer Kontakt zwischen Bedienperson und Berührungssensor zu verstehen; es genügt vielmehr dass die Berührungsperson durch Annähern an den Berührungssensor diesen, insbesondere durch ändern der kapazitiven Eigenschaften so beeinflusst, sodass er ein Bediensignal erzeugt.

Das erfindungsgemäße Anordnen der Berührungssensoren sowie der Logikmittel auf einer gemeinsamen Leiterplatte wird dadurch ermöglicht, dass ein Logikmittelabschnitt vorgesehen ist, in dem die gemeinsame Leiterplatte eben ausgebildet ist. In diesem Logikmittelabschnitt sind die Logikmittel (bevorzugt mindestens ein Mikrocontroller), und bevorzugt alle oberflächenmontierten Bauteile, insbesondere den Berührungssensoren zugeordnete Messwiderstände bzw. Vorwiderstände, angeordnet.

Erfindungsgemäß ist vorgesehen auf einer gemeinsamen Leiterplatte sowohl einen unebenen Berührungssensorabschnitt wie auch einen ebenen Logikmittelabschnitt vorzusehen und trotzdem den Sensorabschnitt ohne Schädigung von Komponenten wie Signalleitungen verformen, insbesondere verbiegen, zu können den Logikmittelabschnitt durch eine Aussparung gegenüber dem erfindungsgemäß flächengrößeren Sensormittelabschnitt abzugrenzen. Die Aussparung ist so ausgebildet und angeordnet, dass bei einem Verformen der Leiterplatte außerhalb des Logikmittelabschnitts die Verformungskraft nicht auf den Logikmittelabschnitt übertragen wird, also der Logikmittelabschnitt nicht (mit) verformt wird sondern nur relativ zu dem Sensorabschnitt ausgelenkt wird.

Die weitere Leiterplatte außerhalb des ebenen Logikmittelabschnitts, also im Sensorabschnitt, ist hingegen zumindest abschnittsweise nicht eben ausgebildet und erstreckt sich aus der Ebene des Logikmittelabschnitts heraus, insbesondere durch Wölbung bzw. Biegung der Leiterplatte.

Eine so ausgestaltete Leiterplatte erlaubt es, bei einer Kaffeemaschine mit unebener Frontblende auf besonders einfache und vorteilhafte Weise Berührungssensoren und Logikmittel so auszubilden und anzuordnen, dass sich eine einfache Montage und eine fehlerunanfälligere Konstruktion ergibt.

Vorteilhafte Weiterbildungen der Erfindung sind in den Unteransprüchen angegeben. In den Rahmen der Erfindung fallen sämtliche Kombinationen aus zumindest zwei von in der Beschreibung, den Ansprüchen und/oder den Figuren offenbarten Merkmalen.

Wird der Logikmittelabschnitt im Bereich von zwei winklig zueinander verlaufenden Randseiten der Leiterplatte angeordnet, ist es möglich, eine Logikmittelabschnittlasche zu bilden, indem ausgehend von einer Randseite parallel zu der winklig dazu verlaufenden Randseite eine Aussparung in der Leiterplatte vorgesehen wird, so dass eine randseitige Lasche entsteht. Befindet sich der Logikmittelabschnitt in einem weiter von einem Rand der Leiterplatte beabstandeten Bereich, kann eine Logikmittellasche beispielsweise dadurch gebildet werden, dass drei winklig zueinander verlaufende, linienartige, bevorzugt im Wesentlichen die Schenkel eines Us zueinander angeordnete gerade oder aber auch gekrümmte Aussparungen in der Leiterplatte vorgesehen werden.

Auch ist es bei entsprechender Anordnung des Logikmittelabschnittes im Wesentlichen in der Nähe nur einer Außenkante der Leiterplatte möglich, durch zwei winklig zueinander verlaufende, bevorzugt wie die Schenkel eines Ls angeordnete Aussparungen eine Logikmittelabschnittlasche zu bilden. Selbstverständlich müssen, wie bereits angedeutet, Aussparungen nicht winklig zueinander angeordnet sein, sondern es kann auch ein gekrümmter Verlauf einer Aussparung gewählt werden. Wesentlich ist nur den Logikmittelabschnitt so auszuklinken, dass er zwar noch einstückig mit dem Sensorabschnitt verbunden ist, der flächengrößere Sensormittelabschnitt jedoch relativ zu dem Logikmittelabschnitt durch Verformung verstellbar ist, ohne dabei die gerade Ausformung des Logikmittelabschnittes zu beeinflussen.

Besonders vorteilhaft sind die Logikmittel, bevorzugt alle oberflächenmontierten Bauteile, auf einer anderen Seite der Leiterplatte als die Berührungssensoren angeordnet, wobei die Berührungssensoren bevorzugt auf einer der Frontblende zugewandeten Seite (also nutzerseitig) der Leiterplatte angeordnet sind. Hierdurch wird zum einen eine Passform an der Außenseite erleichtert, da diese keine hervorstehenden Bauteile aufweist. Zum anderen werden kapazitive Störungen zu der Außenseite, die die Berührungssensoren beeinträchtigen könnten, hierdurch vermieden.

Bevorzugt ist der Logikmittelabschnitt spannungsfrei, er weist also keine inhärente Kraft auf, die seine Form ändern will, insbesondere keine Rückstellkraft gegen eine elastische Verformung.

Hierdurch wird insbesondere verhindert, dass die Logikmittel und/oder weitere im Logikmittelabschnitt angebrachte Bauteile sich durch eine Oberflächenspannung von der Leiterplatte ablösen.

Besonders bevorzugt ist der Logikmittelabschnitt ausschließlich über eine Gerade mit der weiteren Leiterplatte, insbesondere dem Sensorabschnitt, verbunden, d.h. der einstückige Übergang zwischen dem Logikmittelabschnitt und dem Sensorabschnitt ist in Draufsicht auf die Leiterplatte durch eine Gerade ausgebildet bzw. in einem Querschnitt ist der Übergang als, bevorzugt rechteckige Fläche, ausgebildet.

Bevorzugt ist der Übergang zwischen Logikmittelabschnitt und der weiteren Leiterplatte, insbesondere dem Sensorabschnitt, flexibel bzw. federnder Art, sodass sich der Logikmittelabschnitt gegenüber dem Sensorabschnitt auslenken lässt.

Der Sensorabschnitt kann, insbesondere zur Anpassung an die Form der Frontblende bzw. des Frontpanels der Kaffeemaschine, zum Erreichen einer Formgebung, die aus der Ebene der Logikmittel heraus geht, plastisch und/oder elastisch verformt sein. Dies hat den Vorteil, dass zunächst eine standardmäßig leicht erhältliche und durch Massenverfahren leicht produzierbare ebene Leiterplatte für die gemeinsame Leiterplatte verwendet werden kann, die durch entsprechendes Umformen in ihre dreidimensional verformte Formgebung gebracht wird.

Bevorzugt sind auf der Seite der Leiterplatte, die dem Benutzer bzw. der Frontblende zugewandt ist und auf der die kapazitiv wirksamen Berührungsdetektionsflächen der Berührungssensoren angebracht sind, also der Nutzer- bzw. Außenseite, insbesondere im Sensorabschnitt, keine oberflächenmontierten Bauteile aufgebracht.

Hierdurch wird es ermöglicht, die Leiterplatte insbesondere lückenlos an die Frontblende anzubringen, was insbesondere Lufteinschlüsse zwischen den kapazitiv wirksamen Flächen und der Frontblende verhindert, wodurch die Detektionsgenauigkeit hinsichtlich eines Berührens der Berührungssensoren durch den Nutzer erhöht wird.

Der mechanische Zusammenhalt der Leiterplatte mit der Frontblende kann durch Klebemittel erreicht werden, die zwischen diesen aufgebracht werden, wobei die Verwendung solcher Klebemittel weiter Lufteinschlüssen entgegen wirken kann.

Alternativ oder ergänzend kann die Leiterplatte durch eine mechanische Spann-, Schnapp- und/oder Rastverbindung, beispielsweise eine Clip-Verbindung, zwischen der Frontblende und einem hinter der Leiterplatte angeordneten weiteren Element fixiert werden, wobei die Leiterplatte bevorzugt durch zumindest abschnittsweise durch einen beidseitigen Anpressdruck in ihrer Position gesichert wird.

Als Material für die Leiterplatte können insbesondere in Epoxidharz getränkte Glasfasermatten, insbesondere FR4, zum Einsatz kommen. Diese sind als übliches Leiterplattenmaterial erprobt und zeichnen sich durch ihre geringen Materialkosten und Materialeigenschaften, insbesondere Flexibilität und elektromagnetische Eigenschaften, für den vorliegenden Anwendungsfall aus.

Als Dicke der Leiterplatte hat sich insbesondere ein Wert zwischen 0,1 mm und 0,4 mm, insbesondere 0,3 mm, als vorteilhaft herausgestellt. Diese Werte bieten einen guten Kompromiss zwischen Biegsamkeit, Platzerfordernis und Stabilität.

Die (Ober-)Flächenerstreckung des Logikmittelabschnitts beträgt einseitig bevorzugt mindestens 2 cm², weiter bevorzugt mindestens 4 cm², besonders bevorzugt mindestens 6 cm². Hierdurch ist ausreichend Platz für Logikmittel in Form von Mikrokontrollern sowie für weitere oberflächenmontierte Bauteile gegeben.

Neben der erfindungsgemäßen gemeinsamen Leiterplatte für Logikmittel und die Berührungssensoren kann zusätzlich eine weitere Leiterplatte im Inneren der Kaffeemaschine, also weiter von der Nutzerseite entfernt als die gemeinsame Leiterplatte, vorgesehen sein. Auf dieser können insbesondere Beleuchtungsmittel zum Beleuchten der Bedieneinheit und/oder weitere funktionale Elemente, wie beispielsweise ein LCD-Display vorgesehen sein. Die gemeinsame Leiterplatte weist bevorzugt Aussparungen auf, die den Beleuchtungsmitteln zugeordnet sind und deren Licht durchlassen. Durch den Abstand der Beleuchtungsmittel zu der gemeinsamen Leiterplatte wird es ermöglicht die Frontblende diffus auszuleuchten, was bei einer Anordnung auf der vorderen Leiterplatte so nicht möglich wäre. Um das Licht von den Beleuchtungsmitteln an die Frontblende zu leiten, können Lichtleitmittel zum Einsatz kommen, die, insbesondere mit Lichtkanälen, das Licht an die gewünschten Stellen der Frontblende leiten. Die Lichtleitmittel umfassen bevorzugt einen Festkörper mit hohlen (Lichtleit-)Kanälen, die weiter bevorzugt eine Erstreckung (in Richtung von Frontblende in das Gehäuseinnere) von mindestens 2 cm aufweisen.

Eine Anordnung der Beleuchtungsmittel auf der vorderen Leiterplatte wäre wegen der unebenen Oberfläche erschwert und mit Bestückungsproblemen verbunden. Hier müssten die Beleuchtungsmittel auf einer Vorderseite der vorderen Leiterplatte angeordnet sein, was zudem einem flächigen Anliegen der Leiterplatte an der Frontblende (mit den vorgenannten Nachteilen) entgegen wirken würde. Auf der Rückseite der vorderen Leiterplatte könnten die Beleuchtungsmittel nur mit umständlichen Konstruktionen wie einem gebogenen Lichtleiter zu einer Aussparung der Leiterplatte realisiert werden, wobei sich hier eine punktförmige Beleuchtung und keine gewünschte diffuse Beleuchtung ergeben würde.

Von besonderem Vorteil ist es, wenn die Signalleitmittel größtenteils, also zu mindestens 90%, bevorzugt vollständig, auf der Rückseite der Leiterbahn verlaufen bzw. angeordnet sind. Durch eine Anordnung an der Vorderseite würden die Signalleitmittel kapazitiv auf äußere Einflüsse reagieren und so möglicherweise die Berührungsdetektion beeinträchtigen, beispielsweise indem ein Berühren der Signalleitmittel ein Berührungsdetektionssignal auslösen würde.

Auf der Frontblende kann, insbesondere durch Siebdruck oder dergleichen, eine lichtdurchlässige Bedruckung aufgebracht sein.
Die Erfindung führt auch auf ein Montageverfahren zum Montieren einer Kaffeemaschine, insbesondere eines Kaffeevollautomaten, bevorzugt einer wie zuvor beschrieben ausgebildeten Kaffeemaschine. Kern des Verfahrens ist es, eine, bevorzugt zunächst noch ebene Bedieneinheit bzw. eine Bedieneinheit mit zunächst noch ebener Leiterplatte bereitzustellen, wobei die Leiterplatte sowohl einen Logikmittelabschnitt, bestückt mit Logikmitteln aufweist, sowie einen Sensorabschnitt mit mindestens einem Berührungssensor. Der Berührungssensor ist ausgebildet zum Erzeugen eines Bediensignals bei einer Berührung durch eine Bedienperson, wobei der Berührungssensor über Signalleitungsmittel auf der Leiterplatte mit den Logikmitteln signalleitend verbunden ist, wobei über die Signalleitungsmittel das Bedienungssignal an die Logikmittel weiterleitbar ist. Die Logikmittel sind im fertig montierten Zustand der Kaffeemaschine mit Kaffeeerzeugungsmitteln signalleitend verbunden, also vor der fertigen Montage mit den Kaffeeerzeugungsmitteln verbindbar. Der Logikmittelabschnitt und der Sensorabschnitt gehen einstückig ineinander über, die Besonderheit besteht darin, dass der Logikmittelabschnitt gegenüber dem Sensorabschnitt durch mindestens eine, bevorzugt laschenartige, Aussparung der Leiterplatte so abgegrenzt ist, dass er beim Verformen des Sensorabschnittes der Logikmittelabschnitt nicht verformt wird. Gemäß einem weiteren Verfahrensschritt wird nun der Sensorabschnitt verformt, insbesondere verbogen, d.h. gewölbt, wobei durch die spezielle Ausgestaltung der Leiterplatte der Logikmittelabschnitt hiervon im Wesentlichen nicht beeinträchtigt wird, sondern in einer geraden Ebene verbleibt, während der Sensorabschnitt verformt, insbesondere gewölbt in den Logikmittelabschnitt übergeht, der aufgrund der Aussparung gerade bleibt. Somit werden Signalleitungen zumindest weitgehend geschont und die Bildung von Haarrissen wird vermieden, was der Lebensdauer der Bedieneinheit zugute kommt.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Fig. 1a: die Rückseite eines Ausführungsbeispiel einer gemeinsamen Leiterplatte zum Einsetzen in eine erfindungsgemäße Kaffeemaschine in einer schematischen Draufsicht,
- Fig. 1b: schematische Ansicht der Leiterplatte aus Fig. 1 a mit den der Rückseite zugeordneten leitenden Schichten,
- Fig. 1c: schematische Ansicht der Leiterplatte aus Fig. 1 a mit den der Vorderseite zugeordneten leitenden Schichten,
- Fig. 2: die Leiterplatte aus Fig. 1 in einer Bedieneinheit mit einer Frontblende, Beleuchtungsmitteln und einer weiteren Leiterplatte,
- Fig. 3: eine alternative Bedieneinheit mit einer randseitigen Anordnung des Logikmittelabschnittes, und
- Fig. 4: eine weitere alternative Anordnung des Logikmittelabschnittes.

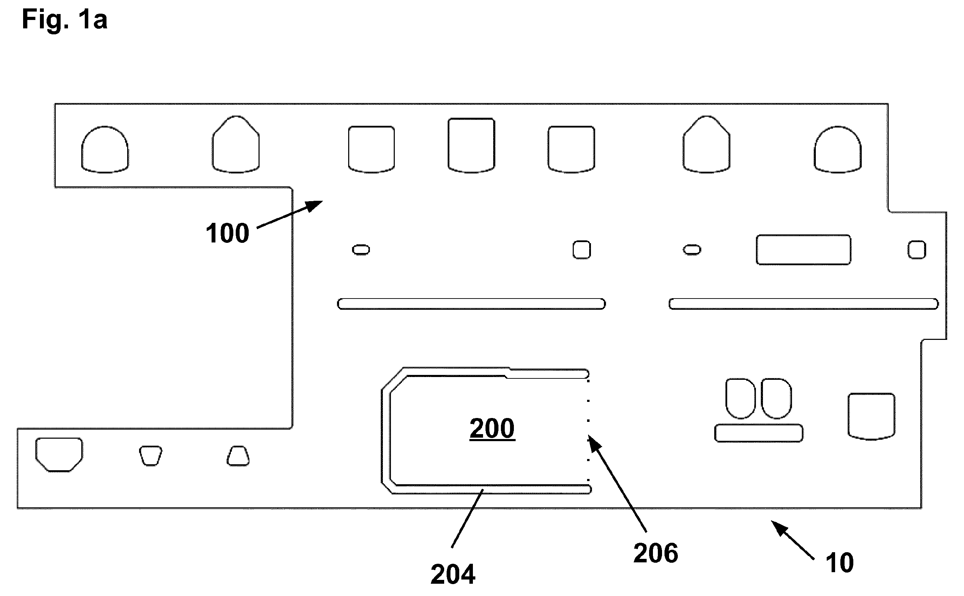

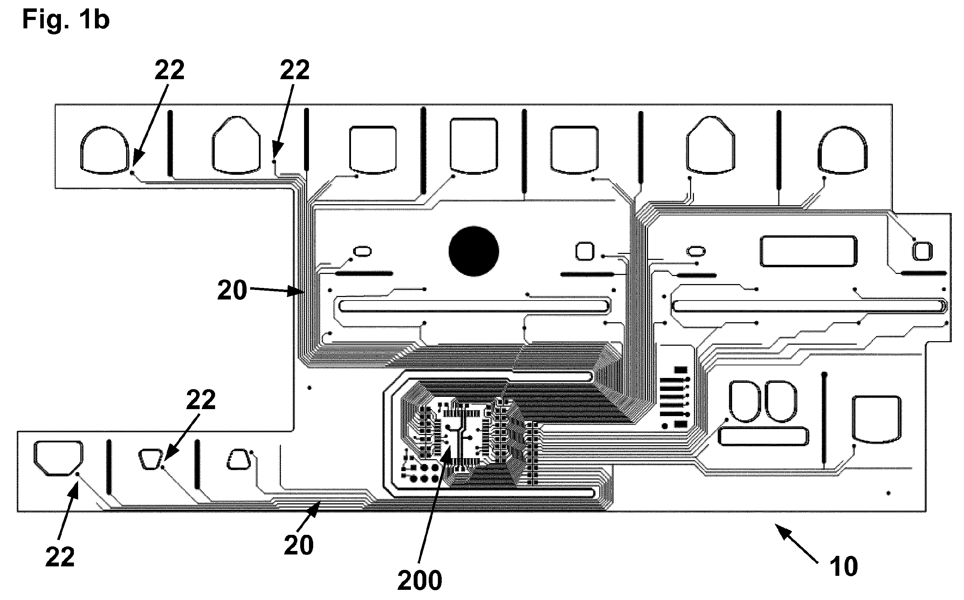

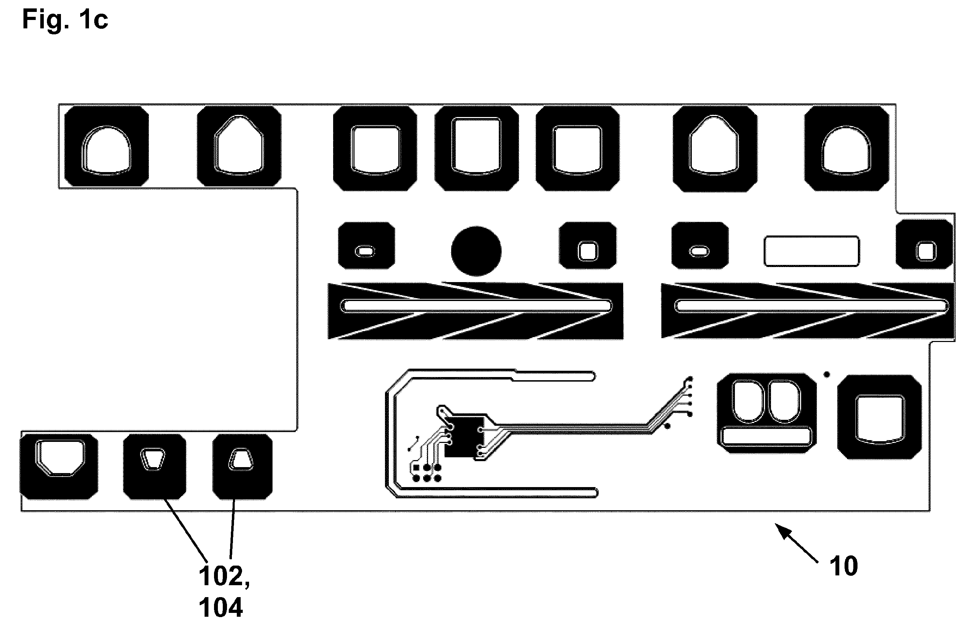

Die in Fig. 1a bis 1c gezeigte Leiterplatte 10 umfasst einen Sensorabschnitt 100 sowie einen Logikmittelabschnitt 200. Im Sensorabschnitt 100 sind (wie insbesondere in Fig. 1c dargestellt) Berührungssensoren 102 mit kapazitiv wirksamen Flächen 104 vorgesehen. Im Logikmittelabschnitt 200 sind Logikmittel 202 vorgesehen. Die kapazitiv wirksamen Flächen 104 sind über rückseitig angeordnete Signalleitungsmittel 20 (wie sie in Fig. 1 b dargestellt sind) mit den Logikmitteln 202 verbunden. Durch elektrisch leitende Durchkontaktierungen 22 sind die vorderseitigen kapazitiv wirksamen Flächen 104 mit den rückseitigen Signalleitungsmitteln 20 elektrisch verbunden.

Der Logikmittelabschnitt 200 ist gegenüber dem Sensorabschnitt 100 durch eine laschenartige Aussparung 204 abgegrenzt. Diese Aussparung 204 ist derart ausgebildet und angeordnet, dass der Logikmittelabschnitt 200 bei einem Verformen des Sensorabschnitts 100 in eine Form, die außerhalb der Ebene des Sensorabschnitts 100 ragt, nicht mit verformt wird, sondern vielmehr als ebene Fläche verbleibt. Ebenso bleibt der Logikmittelabschnitt 200 nach dem Verformen des Sensorabschnitts 100 spannungsfrei.

Der Logikmittelabschnitt 200 geht einstückig in den Sensorabschnitt 100 über, wobei der Übergang in der Draufsicht entlang einer einstückig durchgehenden Geraden 206 erfolgt.

Die Leiterplatte 10 ist aus FR4 mit einer Dicke von 0,3 mm hergestellt. Hierdurch ergibt sich eine gute Stabilität, wobei die Leiterplatte 10 flexibel genug ist, um ein einfaches Verformen des Sensorabschnitts 100 zu gewährleisten und auch eine federnde Lagerung des Logikmittelabschnitts 200 gegenüber dem Sensorabschnitt 100 ermöglicht.

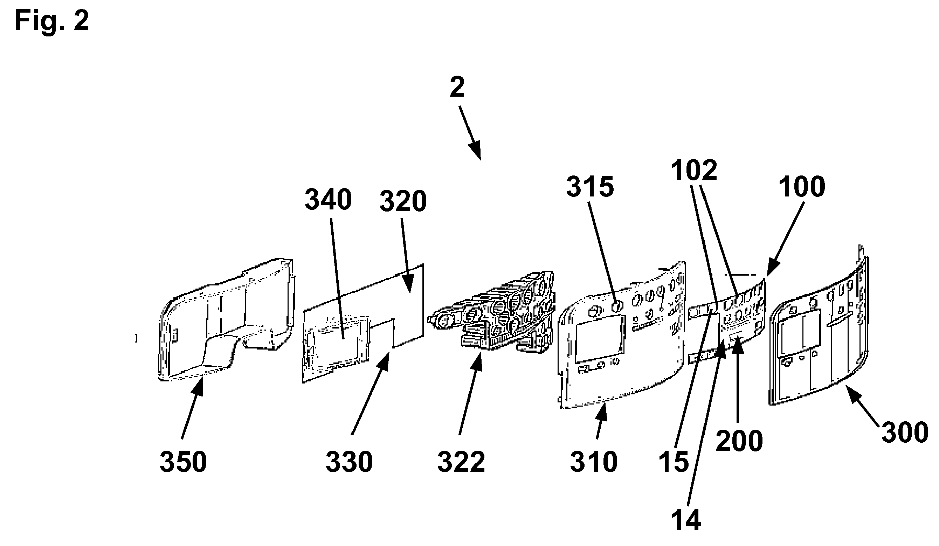

Fig. 2 zeigt den Einsatz der in Fig. 1 gezeigten Leiterplatte 10 in einer Bedieneinheit einer Kaffeemaschine in einer Explosionsdarstellung.

Die Vorderseite 14 der Leiterplatte 10 ist hierbei passgenau an die Kontur einer Frontblende 300 angepasst. Die Vorderseite 14 ist hier im Wesentlich glatt ausgebildet, insbesondere sind auf ihr keine oberflächenmontierte Bauteile aufgebracht. Gegenüber der Frontblende 300 ist die Leiterplatte 10 lückenlos durch ein Klebemittel verbunden, wobei hierdurch ungewünschte Lufteinschlusse verhindert werden, die das Detektionssignal der Berührungssensoren 102 negativ beeinflussen würden.

Die Leiterplatte 10 liegt rückseitig an einem ersten Trägerelement 310 in Form eines Kunststoffformteils an.

Alternativ oder ergänzend zu der vorbeschriebenen Klebeverbindung zwischen Leiterplatte 10 und der Frontblende 300, könnte die Leiterplatte 10 auch mechanisch an der Frontblende 300 festgelegt werden, beispielsweise indem zwischen der Frontblende 300 und dem ersten Trägerelement 310 eine Spann-, Schnapp- und/oder Rastverbindung, insbesondere Clipverbindung, vorgesehen wird, die die Leiterplatte durch beidseitigen Anpressdruck in ihrer Position fixiert.

Weiter im Inneren der Kaffeemaschine ist dem Trägerelement 310 eine weitere Leiterplatte 330 nachgeordnet, auf der Beleuchtungsmittel 320 in Form von LEDs angeordnet sind, die zum Beleuchten der Frontblende 300 dienen.

Das Licht der Beleuchtungsmittel 320 wird über Lichtleitmittel 322, welches Lichtkanäle umfasst, an die vorderen Teile der Kaffeemaschine weitergeleitet. Die Lichtleitmittel 322 sind bevorzugt mit dem Trägerelement 310 fest verbunden, insbesondere verschraubt, und bilden gemeinsam mit diesem ein tragendes Element.

Sowohl die Leiterplatte 10 als auch das erste Trägerelement 310 weisen zudem Aussparungen 15 bzw. 315 auf, die zum Durchlassen von Licht, welches durch die zu diesen rückseitigen Beleuchtungsmittel 320 erzeugt wurde, und durch die Lichtleitmittel 322 weitergeleitet wurde, ausgebildet und angeordnet sind.

An der weiteren Leiterplatte 330 ist weiterhin ein Display 340 angebracht, das durch entsprechende Aussparungen in den Lichtleitmitteln 322, dem Trägerelement 310 und der Leiterplatte 10 über die Frontblende 300 bedienbar ist. Das Display kann, um einen etwaigen Versatz auszugleichen, gegenüber der weiteren Leiterplatte 330 versetzt sein.

Hinter der weiteren Leiterplatte 330 ist ein zweites Trägerelement 350 angeordnet, dass passgenau so mit dem ersten Trägerelement 310 zusammenwirken kann, dass die Lichtleitmittel 322 sowie die weitere Leiterplatte 330 durch sie eingeschlossen werden.

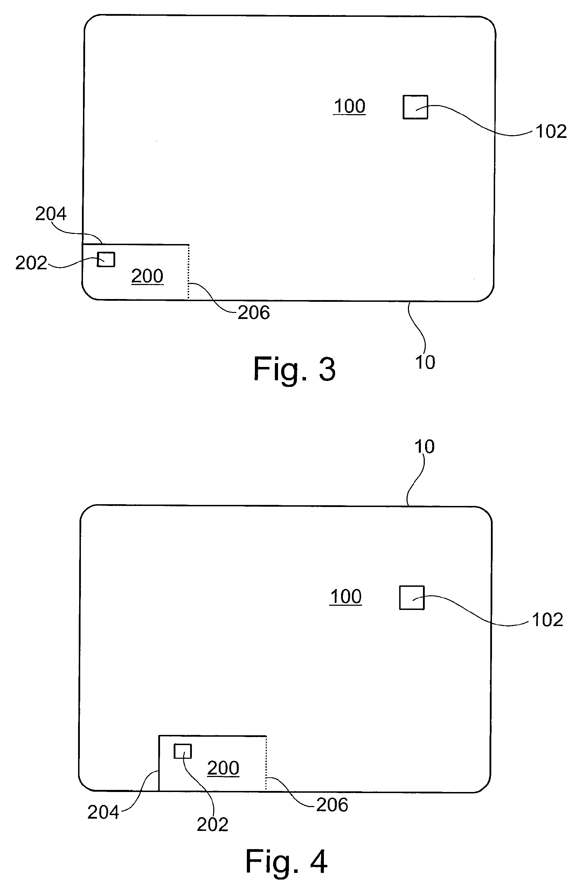

In den Fig. 3 und 4 sind alternative Leiterplattenkonfigurationen stark schematisiert und lediglich beispielhaft gezeigt. In beiden Fällen ergibt sich eine Logikmittelabschnittlasche, jedoch durch eine unterschiedliche Anzahl von winklig zueinander angeordneten Aussparungen, bzw. durch unterschiedlich lange bzw. große Aussparungen.

Bei dem Ausführungsbeispiel gemäß Fig. 3 befindet sich der Logikmittelabschnitt 200 benachbart zu zwei winklig zueinander verlaufenden Randseiten, ist also eckseitig angeordnet, so dass es ausreicht, durch das Vorsehen einer, hier beispielhaft geraden Aussparung 204 einen laschenartigen Logikmittelabschnitt zu erzeugen, der im Bereich einer einstückig durchgehenden Gerade 206 in den Sensorabschnitt 100 übergeht.

Durch die nicht eckseitige, jedoch randseitige Anordnung des Logikmittelabschnittes 200 benachbart zu einer einzigen Randseite der Leiterplatte 10 kann die Laschenform des Logikmittelabschnittes erreicht werden durch zwei winklig zueinander angeordneten Aussparungen 204 oder alternativ über eine in der Form eines halben U's gekrümmte Aussparung - wesentlich ist die Auslenkbarkeit des Sensorabschnittes 100 um die durchgehende Gerade 206 relativ zum Logikmittelabschnit 200, der bei einer Verformung des Sensorabschnittes 100 sich gerade aus der sich ergebenden Krümmung des Sensorabschnittes heraus erstreckt, wodurch nicht gezeigte, die durchgehende Gerade 206 kreuzende, Signalleitungsmittel im Bereich des Logikmittelabschnittes nicht und im Übergangsbereich zum Sensorabschnitt 100 nur geringfügig gekrümmt werden.

### Bezugszeichen:

- 1: Kaffeemaschine
- 2: Bedieneinheit

- 10: Leiterplatte
- 12: Rückseite
- 15: Aussparung der Leiterplatte
- 20: Signalleitungsmittel
- 22: Durchkontaktierung

- 100: Sensorabschnitt
- 102: Berührungssensoren

- 200: Logikmittelabschnitt
- 202: Logikmittel
- 204: Aussparung
- 206: einstückig durchgehende Gerade

- 300: Frontblende
- 310: Trägerelement
- 315: Aussparung des Trägerelements
- 320: Beleuchtungsmittel
- 322: Lichtleitmittel
- 330: weitere Leiterplatte
- 350: zweites Trägerelement

## Patentansprüche

1. Kaffeemaschine (1), insbesondere Kaffeevollautomat,
umfassend eine Bedieneinheit (2) mit mindestens einem, bevorzugt kapazitiven, Berührungssensor (102) zum Erzeugen eines Bedienungssignals bei einer Berührung durch eine Bedienperson, und Signalleitungsmitteln (20), die das Bedienungssignal an Logikmittel (202) leitend ausgebildet sind, welche mit Kaffeeerzeugungsmitteln signalleitend verbunden sind, wobei der Berührungssensor (102), die Signalleitungsmittel (20) und die Logikmittel (202) auf einer gemeinsamen Leiterplatte (10) angeordnet sind, wobei die Logikmittel (202) in einem ebenen Logikmittelabschnitt (200) der Leiterplatte (10) angeordnet sind, und der Berührungssensor (102) in einem Sensorabschnitt (100) auf der Leiterplatte (10) angeordneten ist, und wobei der Logikmittelabschnitt (200) einstückig in den Sensorabschnitt (100) übergeht, wobei der als Logikmittelabschnittlasche ausgebildete Logikmittelabschnitt (200) gegenüber dem Sensorabschnitt (100) durch mindestens eine Aussparung (204) in der Leiterplatte so abgegrenzt ist, dass bei einem Verformen des Sensorabschnitts (100) der Logikmittelabschnitt (200) nicht verformt wird, und dass sich der Sensorabschnitt (100) aus der Ebene des Logikmittelabschnitts (200), insbesondere gewölbt, heraus erstreckt und dass der Logikmittelabschnitt (200) einstückig in den Sensorabschnitt (100) übergeht,
**dadurch gekennzeichnet,**
**dass** der Logikmittelabschnitt (20) aus dem flächengrößeren Sensorabschnitt (100) ausgeklinkt ist.

2. Kaffeemaschine nach Anspruch 1,
**dadurch gekennzeichnet,**
**dass** die Logikmittel (202) auf einer dem nutzerseitig angeordneten Berührungssensor (102) abgewandten Rückseite (12) der Leiterplatte (10) angeordnet sind.

3. Kaffeemaschine nach einem der vorhergehenden Ansprüche,
**dadurch gekennzeichnet,**
**dass** der Logikmittelabschnitt (200) spannungsfrei ist.

4. Kaffeemaschine nach einem der vorhergehenden Ansprüche,
**dadurch gekennzeichnet,**
**dass** der Logikmittelabschnitt (200) in einer Draufsicht auf die Leiterplatte (10) nur entlang einer einstückig durchgehenden Geraden (206) mit der restlichen Leiterplatte (10) verbunden ist.

5. Kaffeemaschine nach einem der vorhergehenden Ansprüche,
**dadurch gekennzeichnet,**
**dass** der Sensorabschnitt (100) aus der Ebene des Logikmittelabschnitts (200) heraus elastisch und/oder plastisch verformt ist.

6. Kaffeemaschine nach einem der vorhergehenden Ansprüche,
**dadurch gekennzeichnet,**
**dass** die Leiterplatte (10) eine Dicke zwischen 0,1 mm und 0,4 mm, insbesondere 0,3 mm, aufweist.

7. Kaffeemaschine nach einem der vorhergehenden Ansprüche,
**dadurch gekennzeichnet,**
**dass** die Leiterplatte (10) in Epoxidharz getränkte Glasfasermatten, insbesondere FR4, umfasst.

8. Kaffeemaschine nach einem der vorhergehenden Ansprüche,
**dadurch gekennzeichnet,**
**dass** der Sensorabschnitt (100) flächig an einer Frontblende (300) anliegend ausgebildet ist, wobei bevorzugt zwischen Sensorabschnitt (100) und Frontblende (300) eine Klebeschicht angeordnet ist, die weiter bevorzugt einen lufteinschlussfreien Übergang zwischen Frontblende (300) und Sensorabschnitt (100), insbesondere in einem kapazitiv wirksamen Flächen (104) der Berührungssensoren (102) zugeordneten Abschnitt, ermöglicht.

9. Kaffeemaschine nach einem der vorhergehenden Ansprüche,
**dadurch gekennzeichnet,**
**dass** die Signalleitmittel (20) zu mindestens 90%, bevorzugt vollständig, auf einer dem Berührungssensor (102) abgewandten Rückseite (12) der Leiterplatte (10) angeordnet sind.

10. Kaffeemaschine nach einem der vorhergehenden Ansprüche,
**dadurch gekennzeichnet,**
**dass** Beleuchtungsmittel (320) zum Beleuchten der Bedieneinheit (2), insbesondere zum rückseitigen Beleuchten der Frontblende (300), vorgesehen sind, die bevorzugt auf einer weiteren, bevorzugt weiter als die gemeinsame Leiterplatte (10) im Innenraum der Kaffeemaschine angeordnete, Leiterplatte (330) angeordnet sind.

11. Kaffeemaschine nach einem der vorhergehenden Ansprüche,
**dadurch gekennzeichnet,**
**dass** die Leiterplatte (10) auf einem Trägerelement (310) aufliegt, das bevorzugt zwischen der Leiterplatte (10) und den Beleuchtungsmitteln (320) angeordnet ist und Aussparungen (315) zum Durchlassen des durch die Beleuchtungsmittel (320) erzeugten Lichts an die Frontblende (300) aufweisen.

12. Kaffeemaschine nach einem der vorhergehenden Ansprüche,
**dadurch gekennzeichnet,**
**dass** die Leiterplatte (10) durch eine Spann-, Steck-, Schnapp- und/oder Rastverbindung, beispielsweise eine Clip-Verbindung, zwischen einer Frontblende (300) und einem Trägerelement (310) in der Position zur Frontblende (300) fixiert ist.

13. Kaffeemaschine nach einem der vorhergehenden Ansprüche,
**dadurch gekennzeichnet,**
**dass** die Kaffeeerzeugungsmittel Wassererhitzungsmittel zum Erhitzen von Wasser und eine Brüheinheit zum Auslaugen des Kaffeepulvers durch das erhitzte Wasser umfassen.

14. Kaffeemaschine nach einem der vorherigen Ansprüche,
**dadurch gekennzeichnet,**
**dass** der Logikmittelabschnitt (200) an einem Träger festgelegt ist.

15. Verfahren zur Montage einer Kaffeemaschine nach einem der vorhergehenden Ansprüche mit den Schritten:
- Bereitstellen einer Bedieneinheit (2) mit mindestens einem, bevorzugt kapazitiven, Berührungssensor (102) zum Erzeugen eines Bediensignals bei einer Berührung durch eine Bedienperson, und mit Signalleitungsmitteln (20) zum Leiten eines Bediensignals an Logikmittel (202) die mit Kaffeeerzeugungsmitteln der Kaffeemaschine signalleitend verbindbar sind, wobei der Berührungssensor (102), die Signalleitungsmittel (20) und die Logikmittel (202) auf einer gemeinsamen Leiterplatte (10) angeordnet sind, und wobei die Logikmittel (202) in einem ebenen Logikmittelabschnitt der Leiterplatte (10) angeordnet sind, und der Berührungssensor (102) in einem flächengrößeren Sensorabschnitt (100) auf der Leiterplatte angeordnet ist, und wobei der Logikmittelabschnitt (200) als Logikmittelabschnittslasche ausgebildet und gegenüber dem Sensorabschnitt (100) durch mindestens eine, bevorzugt laschenartige, Aussparung (204) in der Leiterplatte so abgegrenzt ist, dass bei einem Verformen des Sensorabschnittes (100) der Logikmittelabschnitt (200) nicht verformt wird, und wobei der Logikmittelabschnitt (200) einstückig in den Sensorabschnitt (100) übergeht;
- Verformen, insbesondere Verbiegen, des Sensorabschnittes (100) aus der Ebene des Logikmittelabschnittes (200) heraus, wobei der Logikmittelabschnitt (204) dabei nicht verformt wird, sondern in einer Ebene verbleibt, aus der sich der Sensorabschnitt (100) nach dem Verformschritt, insbesondere gebogen, heraus erstreckt.

## Claims

1. A coffee machine (1), in particular a fully automatic coffee machine, comprising an operating unit (2), which has at least one, preferably capacitive, touch sensor (102) for producing an operation signal when touched by an operating person and signal-conducting means (20) that are designed to conduct the operation signal to logic means (202), which are connected to coffee-producing means in a signal-conducting manner, wherein the touch sensor (102), the signal-conducting means (20), and the logic means (202) are arranged on a common circuit board (10), wherein the logic means (202) are arranged in a flat logic-means section (200) of the circuit board (10), and the touch sensor (102) is arranged in a sensor section (100) on the circuit board (10), and wherein the logic means section (200) integrally transitions into the sensor section (100), wherein the logic means section (200), constructed as logic means section tab, is delimited from the sensor section (100) by at least one opening (204) in the circuit board in such a way that the logic-means section (200) is not deformed when the sensor section (100) is deformed, and that the sensor section (100) extends out from the plane of the logic means section (200), in particular in an arched manner, and that the logic means section (200) integrally transitions into the sensor section (100),
**characterized in that**
the logic means section (20) is released from the sensor section (100), which has a larger area.

2. The coffee machine according to Claim 1,
**characterized in that**
the logic means (202) are arranged on a rear side (12) of the circuit board (10) facing way from the touch sensor (102) which is arranged on the user side.

3. The coffee machine according to one of the preceding claims,
**characterized in that**
the logic means section (200) is de-energized.

4. The coffee machine according to one of the preceding claims,
**characterized in that**
in a top view onto the circuit board (10), the logic means section (200) is only connected to the remaining circuit board (10) along an integrally continuous straight line (206).

5. The coffee machine according to one of the preceding claims,
**characterized in that**
the sensor section (100) is elastically and/or plastically deformed out of the plane of the logic means section (200).

6. The coffee machine according to one of the preceding claims,
**characterized in that**
the circuit board (10) has a thickness of between 0.1 mm and 0.4 mm, in particular 0.3 mm.

7. The coffee machine according to one of the preceding claims,
**characterized in that**
the circuit board (10) comprises glass fibre mats which are saturated in epoxy resin, in particular FR4.

8. The coffee machine according to one of the preceding claims,
**characterized in that**
the sensor section (100) is embodied so as to lie flat against a front panel (300), wherein an adhesive layer is preferably arranged between sensor section (100) and front panel (300), which adhesive layer further preferably enables an air pocket-free transition between front panel (300) and sensor section (100), in particular in a section associated with capacitively effective surfaces (104) of the touch sensors (102).

9. The coffee machine according to one of the preceding claims,
**characterized in that**
the signal-conducting means (20) are arranged at at least 90%, preferably completely, on a rear side (12) of the circuit board (10) facing away from the touch sensor (102).

10. The coffee machine according to one of the preceding claims,
**characterized in that**
illuminating means (320) are provided for illuminating the operating unit (2), in particular for illuminating the front panel (300) on the rear side, which illuminating means are preferably arranged on a further circuit board (330), preferably arranged farther in the interior of the coffee machine than the common circuit board (10).

11. The coffee machine according to one of the preceding claims,
**characterized in that**
the circuit board (10) rests on a support element (310), which is preferably arranged between the circuit board (10) and the illuminating means (320) and has openings (315) for allowing the light, generated by the illuminating means (320), to pass to the front panel (300).

12. The coffee machine according to one of the preceding claims,
**characterized in that**
the circuit board (10) is fixed in the position to the front panel (300) by means of a clamping-, plug-, snap- and/or detent connection, for example a clip connection, between a front panel (300) and a support element (310).

13. The coffee machine according to one of the preceding claims,
**characterized in that**
the coffee-producing means comprise water-heating means for the heating of water and a brewing unit for leaching out the coffee powder by means of the heated water.

14. The coffee machine according to one of the preceding claims,
**characterized in that**
the logic means section (200) is fixed to a support.

15. A method for mounting a coffee machine according to one of the preceding claims, with the steps:
- providing an operating unit (2) which has at least one, preferably capacitive, touch sensor (102) for producing an operation signal when touched by an operating person, and with signal-conducting means (20) for conducting an operation signal to logic means (202) which are able to be connected in a signal-conducting manner to coffee-producing means of the coffee machine, wherein the touch sensor (102), the signal-conducting means (20) and the logic means (202) are arranged on a common circuit board (10), and wherein the logic means (202) are arranged in a flat logic means section of the circuit board (10), and the touch sensor (102) is arranged in a sensor section (100) having a larger area on the circuit board, and wherein the logical means section (200) is constructed as a logic means section tab and is delimited from the sensor section (100) by at least one, preferably tablike, opening (204) in the circuit board in such a way that the logic means section (200) is not deformed when the sensor section (100) is deformed, and wherein the logic means section (200) integrally transitions into the sensor section (100);
- deforming, in particular bending, the sensor section (100) out of the plane of the logic means section (200), wherein the logic means section (204) is not deformed thereby, but rather remains in a plane out of which the sensor section (100) extends, in particular in a curved manner, after the deforming step.

## Revendications

1. Machine à café (1), en particulier machine à café automatique, comprenant une unité de commande (2) avec au moins un détecteur de contact (102), de préférence capacitif, pour la production d'un signal de commande lors d'un contact par un opérateur, et des moyens de transmission de signal (20), qui sont conçus pour conduire le signal de commande à des moyens logiques (202), qui sont en liaison de conduction de signal avec des moyens de production de café, dans laquelle le détecteur de contact (102), les moyens de transmission de signal (20) et les moyens logiques (202) sont disposés sur une plaquette de circuits imprimés commune (10), dans laquelle les moyens logiques (202) sont disposés dans une partie de moyens logiques plane (200) de la plaquette de circuits imprimés (10) et le détecteur de contact (102) est disposé dans une partie de détecteur (100) de la plaquette de circuits imprimés (10), et dans laquelle la partie de moyens logiques (200) se prolonge d'une seule pièce dans la partie de détecteur (100), dans laquelle la partie de moyens logiques (200) réalisée sous la forme d'une patte de partie de moyens logiques est délimitée par rapport à la partie de détecteur (100) par au moins une découpe (204) dans la plaquette de circuits imprimés, de telle manière que lors d'une déformation de la partie de détecteur (100) la partie de moyens logiques (200) ne soit pas déformée, et que la partie de détecteur (100) s'étende, en particulier s'incurve, hors du plan de la partie de moyens logiques (200), et que la partie de moyens logiques (200) se prolonge d'une seule pièce dans la partie de détecteur (100), **caractérisée en ce que** la partie de moyens logiques (20) est entaillée hors de la partie de détecteur (100) de surface plus grande.

2. Machine à café selon la revendication 1, **caractérisée en ce que** les moyens logiques (202) sont disposés sur une face arrière (12) de la plaquette de circuits imprimés (10) détournée du détecteur de contact (102) disposé du côté de l'utilisateur.

3. Machine à café selon l'une quelconque des revendications précédentes, **caractérisée en ce que** la partie de moyens logiques (200) est libre de contraintes.

4. Machine à café selon l'une quelconque des revendications précédentes, **caractérisée en ce que** la partie de moyens logiques (200) est reliée, dans une vue en plan de la plaquette de circuits imprimés (10), au reste de la plaquette de circuits imprimés (10) uniquement le long d'une droite continue d'une seule pièce (206).

5. Machine à café selon l'une quelconque des revendications précédentes, **caractérisée en ce que** la partie de détecteur (100) est déformée élastiquement et/ou plastiquement hors du plan de la partie de moyens logiques (200).

6. Machine à café selon l'une quelconque des revendications précédentes, **caractérisée en ce que** la plaquette de circuits imprimés (10) présente une épaisseur comprise entre 0,1 mm et 0,4 mm, en particulier de 0,3 mm.

7. Machine à café selon l'une quelconque des revendications précédentes, **caractérisée en ce que** la plaquette de circuits imprimés (10) comprend des renforts de fibres de verre, imprégnés de résine époxyde, en particulier FR4.

8. Machine à café selon l'une quelconque des revendications précédentes, **caractérisée en ce que** la partie de détecteur (100) est réalisée en application sur un écran frontal (300), dans laquelle est disposée de préférence entre la partie de détecteur (100) et l'écran frontal (300) une couche de colle, qui de préférence encore permet une transition sans inclusion d'air entre l'écran frontal (300) et la partie de détecteur (100), en particulier dans une partie associée à des faces à action capacitive (104) des détecteurs de contact (102).

9. Machine à café selon l'une quelconque des revendications précédentes, **caractérisée en ce que** les moyens de transmission de signal (20) sont disposés à raison d'au moins 90 %, de préférence totalement, sur un côté arrière (12) de la plaquette de circuits imprimés (10) détournée du détecteur de contact (102).

10. Machine à café selon l'une quelconque des revendications précédentes, **caractérisée en ce qu'**il est prévu des moyens d'éclairage (320) pour l'éclairage de l'unité de commande (2), en particulier pour l'éclairage par l'arrière de l'écran frontal (300), qui sont disposés de préférence sur une autre plaquette de circuits imprimés (330) que la plaquette de circuits imprimés commune (10), disposée de préférence plus à l'intérieur de la machine à café.

11. Machine à café selon l'une quelconque des revendications précédentes, **caractérisée en ce que** la plaquette de circuits imprimés (10) repose sur un élément de support (310), qui est disposé de préférence entre la plaquette de circuits imprimés (10) et les moyens d'éclairage (320) et qui présente des découpes (315) pour le passage de la lumière produite par les moyens d'éclairage (320) à l'écran frontal (300).

12. Machine à café selon l'une quelconque des revendications précédentes, **caractérisée en ce que** la plaquette de circuits imprimés (10) est fixée en position par rapport à l'écran frontal (300) par un assemblage par serrage, par emboîtement, par déclic et/ou par encliquetage, par exemple un assemblage par clipsage, entre un écran frontal (300) et un élément de support (310).

13. Machine à café selon l'une quelconque des revendications précédentes, **caractérisée en ce que** les moyens de production de café comprennent des moyens de chauffage d'eau pour le chauffage de l'eau et une unité de percolation pour infuser la poudre de café au moyen de l'eau chauffée.

14. Machine à café selon l'une quelconque des revendications précédentes, **caractérisée en ce que** la partie de moyens logiques (200) est fixée sur un support.

15. Procédé de montage d'une machine à café selon l'une quelconque des revendications précédentes, comprenant les étapes suivantes:
- préparation une unité de commande (2) avec au moins un détecteur de contact (102), de préférence capacitif, pour la production d'un signal de commande lors d'un contact par un opérateur, et avec des moyens de transmission de signal (20) pour conduire un signal de commande à des moyens logiques (202), qui peuvent être mis en liaison de conduction de signal avec des moyens de production de café de la machine à café, dans laquelle le détecteur de contact (102), les moyens de lignes de signalisation (20) et les moyens logiques (202) sont disposés sur une plaquette de circuits imprimés commune (10), et dans laquelle les moyens logiques (202) sont disposés dans une partie de moyens logiques plane de la plaquette de circuits imprimés (10) et le détecteur de contact (102) est disposé dans une partie de détecteur (100) de plus grande surface sur la plaquette de circuits imprimés, et dans laquelle la partie de moyens logiques (200) est réalisée sous la forme d'une patte de partie de moyens logiques et est délimitée par rapport à la partie de détecteur (100) par au moins une découpe (204), de préférence en forme de patte, dans la plaquette de circuits imprimés, de telle manière que lors d'une déformation de la partie de détecteur (100) la partie de moyens logiques (200) ne soit pas déformée, et dans laquelle la partie de moyens logiques (200) se prolonge d'une seule pièce dans la partie de détecteur (100);
- déformation, en particulier courbure, la partie de détecteur (100) hors du plan de la partie de moyens logiques (200), dans laquelle la partie de moyens logiques (204) n'est pas déformée, mais reste dans un plan, hors duquel la partie de détecteur (100) s'étend après l'étape de déformation, en particulier de courbure.
